# EUROPÄISCHE PATENTANMELDUNG

(11) **EP 2 230 766 A1**
(43) Veröffentlichungstag der Anmeldung: **22.09.2010**
(21) Anmeldenummer: 10156337.7
(22) Anmeldetag: 12.03.2010
(51) Int. Cl.: H03K 17/955

(54) **Schaltungsanordnung zum Bestimmen einer Kapazität eines kapazitiven Sensorelements**

(30) Priorität: 19.03.2009 DE 102009013532
(71) Anmelder: E.G.O. Control Systems GmbH, 72336 Balingen (DE)
(72) Erfinder: Seeburger, Günther, 78166, Donaueschingen (DE)
(74) Vertreter: Patentanwälte Ruff, Wilhelm, Beier, Dauster & Partner

(57) **Zusammenfassung**

Eine Schaltungsanordnung zum Bestimmen einer Kapazität eines kapazitiven Sensorelements (C1) umfasst eine Rechteckspannungsquelle (10), die dazu ausgebildet ist, an einem Ausgabeanschluss (11) eine Rechteckspannung (UR) auszugeben, einen Sensorzweig, über den das Sensorelement mit der Rechteckspannung beaufschlagt ist, und einen Verstärkerzweig, umfassend einen Gegenkopplungswiderstand (R1), einen Transistor (T1) und einen Auswertekondensator (C2), wobei der Gegenkopplungswiderstand, der Transistor und der Auswertekondensator seriell zwischen den Ausgabeanschluss der Rechteckspannungsquelle und ein Bezugspotential (GND) eingeschleift sind und an dem Auswertekondensator eine Spannung (UOUT) ansteht, die ein Maß für die Kapazität des Sensorelements ist.

## Beschreibung

Die Erfindung betrifft eine Schaltungsanordnung zum Bestimmen einer Kapazität eines kapazitiven Sensorelements.

Schaltungsanordnungen zur Auswertung kapazitiver Sensorelemente, beispielsweise in Form kapazitiver Näherungsschalter, sind bekannt und weisen beispielsweise bei der EP 0 859 468 A1 ein kapazitives Sensorelement auf, dessen Kapazität sich in Abhängigkeit von seinem Betätigungszustand ändert. Diese Kapazitätsänderung wird ausgewertet, um den Betätigungszustand zu ermitteln.

### Aufgabe und Lösung

Der Erfindung liegt als Aufgabe die Bereitstellung einer Schaltungsanordnung zum Bestimmen einer Kapazität eines kapazitiven Sensorelements zugrunde, die eine zuverlässige Bestimmung der Kapazität unter allen Betriebsbedingungen gewährleistet, kostengünstig herstellbar und unempfindlich gegenüber EMV- und HF-Störungen ist.

Die Erfindung löst diese Aufgabe durch eine Schaltungsanordnung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die erfindungsgemäße Schaltungsanordnung zum Bestimmen einer Kapazität eines kapazitiven Sensorelements umfasst eine Rechteckspannungsquelle, die dazu ausgebildet ist, an einem Ausgabeanschluss eine Rechteckspannung auszugeben, einen Sensorzweig, über den das Sensorelement mit der Rechteckspannung beaufschlagt ist, wobei bevorzugt über den Sensorzweig eine Sensorgröße, beispielsweise ein Sensorstrom, übertragen wird, einen Verstärkerzweig, insbesondere zur Verstärkung der Sensorgröße, beispielsweise zur Verstärkung des Sensorstroms, umfassend einen Gegenkopplungswiderstand, einen Transistor und einen Auswertekondensator, wobei der Gegenkopplungswiderstand, der Transistor und der Auswertekondensator seriell zwischen den Ausgabeanschluss der Rechteckspannungsquelle und ein Bezugspotential eingeschleift sind und an dem Auswertekondensator, insbesondere an einem Verbindungsknoten des Transistors und des Auswertekondensators, eine Spannung ansteht, die ein Maß für die Kapazität des Sensorelements ist. Der Gegenkopplungswiderstand im Verstärkerzweig reduziert die Empfindlichkeit der Schaltung gegenüber Bauteilstreuungen, beispielsweise gegenüber Parameterstreuungen des Transistors, d.h. der Transistor kann beispielsweise ein unselektierter Transistor sein.

In einer Weiterbildung umfasst die Rechteckspannungsquelle eine Ladungspumpe. Alternativ kann die Rechteckspannungsquelle auch eine Spannungsvervielfacherschaltung, beispielsweise eine Hochspannungskaskade oder Villard-Vervielfacherschaltung, umfassen.

In einer Weiterbildung ist die Rechteckspannungsquelle dazu ausgebildet, eine Rechteckspannung mit einem Spannungshub größer als 20V, bevorzugt größer als 30V, auszugeben. Besonders bevorzugt ist die Rechteckspannungsquelle dazu ausgebildet, eine Rechteckspannung mit einem Spannungshub von 35V auszugeben. Unter dem Begriff Spannungshub wird vorliegend die Spannungs- bzw. Potentialdifferenz zwischen den zwei unterschiedlichen Spannungszuständen der Rechteckspannung verstanden. Durch den vergleichsweise großen Spannungshub wird die Verstärkungsreduktion kompensiert, die durch den Gegenkopplungswiderstand verursacht wird. Die Kombination von Gegenkopplung und großem Spannungshub ermöglicht eine gleichbleibende oder vergrößerte Auswerteempfindlichkeit bei reduzierter Empfindlichkeit der Schaltung gegenüber Bauteilstreuungen.

In einer Weiterbildung umfasst die Rechteckspannungsquelle eine Zener-Diode, die zwischen den Ausgabeanschluss der Rechteckspannungsquelle und das Bezugspotential eingeschleift ist und die die Rechteckspannung auf einen maximalen Spannungspegel begrenzt.

In einer Weiterbildung ist der Transistor ein pnp-Transistor, wobei der Gegenkopplungswiderstand, die Emitter-Kollektor-Strecke des Transistors und der Auswertekondensator seriell zwischen den Ausgabeanschluss der Rechteckspannungsquelle und das Bezugspotential eingeschleift sind und der Basisanschluss des Transistors mit einem Anschluss des kapazitiven Sensorelements verbunden ist.

In einer Weiterbildung ist ein Entladewiderstand vorgesehen, der dem Auswertekondensator parallel geschaltet ist. Der Entladewiderstand bewirkt eine kontinuierliche Entladung des Auswertekondensators, sodass sich eine mittlere Spannung am Auswertekondensator einstellt, die von der Kapazität des Sensorelements abhängt.

In einer Weiterbildung ist eine Diode vorgesehen, die in Durchflussrichtung zwischen den Transistor und den Auswertekondensator eingeschleift ist. Die Diode verhindert ein Entladen des Auswertekondensators während Zeitintervallen, in denen die Rechteckspannung einen niedrigen Pegel aufweist, und erhöht somit die Auswerteempfindlichkeit. Die Diode kann als Transistor ausgeführt sein, der als Diode beschaltet ist. Bevorzugt sind für diesen Fall der oben genannte Transistor und der als Diode beschaltete Transistor teil eines Doppeltransistors.

In einer Weiterbildung ist ein Spannungsteiler vorgesehen, wobei der Spannungsteiler zwischen den Ausgabeanschluss der Rechteckspannungsquelle und einen Anschluss des kapazitiven Sensorelements eingeschleift ist, wobei ein Mittenabgriff des Spannungsteilers mit einem Steuereingang des Transistors verbunden ist. Der Spannungsteiler dient der Bedämpfung von Störungen.

### Kurzbeschreibung der Zeichnungen

Vorteilhafte Ausführungsformen der Erfindung sind in den Zeichnungen schematisch dargestellt und werden nachfolgend beschrieben. Hierbei zeigt:
- Fig. 1: ein Schaltbild einer ersten Ausführungsform einer Schaltungsanordnung zum Bestimmen einer Kapazität eines kapazitiven Sensorelements, dessen Kapazität sich in Abhängigkeit von seinem Betätigungszustand ändert, und
- Fig. 2: ein Schaltbild einer weiteren Ausführungsform einer Schaltungsanordnung zum Bestimmen einer Kapazität eines kapazitiven Sensorelements, dessen Kapazität sich in Abhängigkeit von seinem Betätigungszustand ändert.

### Detaillierte Beschreibung der Zeichnungen

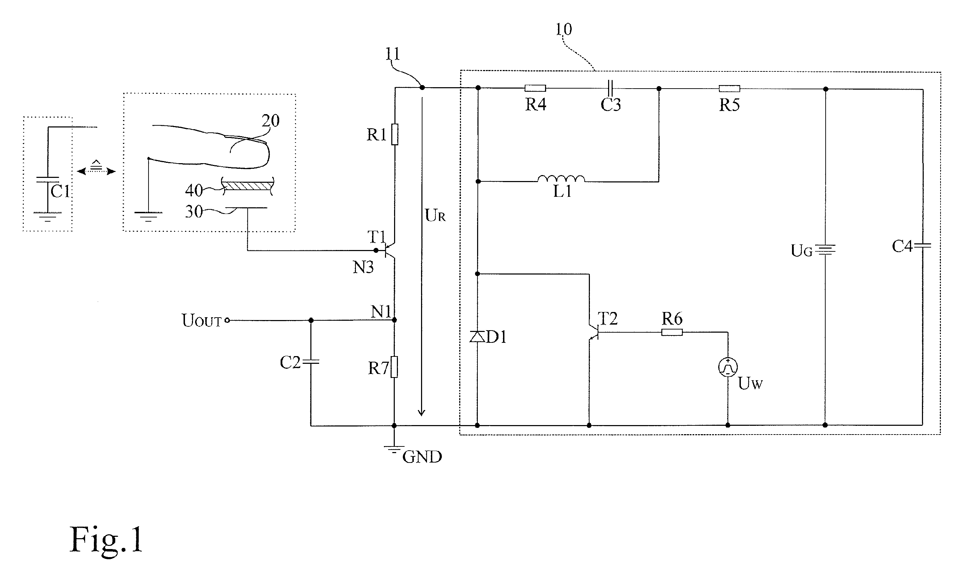

Fig. 1 zeigt ein Schaltbild einer ersten Ausführungsform einer Schaltungsanordnung zum Bestimmen einer Kapazität eines kapazitiven Sensorelements C1, dessen Kapazität sich in Abhängigkeit von seinem Betätigungszustand ändert.

Das kapazitive Sensorelement bildet einen Kondensator C1, wobei eine erste Kondensatorplatte 30 beispielsweise durch eine leitfähige, ebene und flächige Schicht gebildet ist, die unter einer Glaskeramikplatte eines Kochfeldes, einem nichtleitenden Bedienblendenmaterial etc. 40 angeordnet sein kann. Eine zweite Kondensatorplatte wird beispielsweise durch einen Finger 20 eines Benutzers bzw. durch den Benutzer selbst gebildet. Die Glaskeramikplatte bzw. das Bedienblendenmaterial 40 bildet ein Dielektrikum zwischen den beiden Kondensatorplatten. Das kapazitive Sensorelement ist durch sein elektrisches Ersatzschaltbild in Form des Kondensators C1 dargestellt.

Die Schaltungsanordnung umfasst eine Rechteckspannungsquelle 10, die dazu ausgebildet ist, an einem Ausgabeanschluss 11 eine Rechteckspannung UR mit einem Spannungshub von 35V auszugeben. Die Rechteckspannung UR nimmt hierbei zwei unterschiedliche Spannungszustände an, nämlich einen ersten Spannungszustand mit einem Spannungspegel von 0V und einen zweiten Spannungszustand mit einem Spannungspegel von 35V und weist folglich einen Spannungshub von 35V auf.

Die Rechteckspannungsquelle 10 umfasst eine Gleichspannungsquelle UG, die eine Gleichspannung, beispielsweise 5V ausgibt, wobei der Gleichspannungsquelle UG ein optionaler Pufferkondensator C4 parallel geschaltet ist. Eine Spule L1, Widerstände R4 und R5, ein Kondensator C3, ein Transistor T2, der durch eine Signalquelle UW über einen Vorwiderstand R6 angesteuert ist, und eine Zener-Diode D1 mit einer Zener-Spannung von 39V bilden in der dargestellten Beschaltung eine Ladungspumpe zur Erzeugung der Rechteckspannung UR. Die Signalquelle UW kann beispielsweise als Mikroprozessorport realisiert sein, der ein Rechtecksignal mit einer Frequenz im Bereich von 5kHz bis 40 kHz, bevorzugt 10kHz bis 20kHz erzeugt. Eine Ruhepegelanpassung bzw. ein Abgleich einer Spannung UOUT, die ein Maß für die Kapazität des Sensorelements C1 ist, kann durch Einstellung eines geeigneten Tastverhältnisses des durch die Signalquelle UW ausgegebenen Rechtecksignals erfolgen.

Die Zener-Diode D1, die zwischen den Ausgabeanschluss 11 der Rechteckspannungsquelle 10 und das Bezugspotential GND eingeschleift ist, begrenzt die die Rechteckspannung UR auf einen maximalen Spannungspegel von 39V.

Ein Verstärkerzweig der Schaltungsanordnung umfasst einen Gegenkopplungswiderstand R1, einen pnp-Transistor T1, einen Auswertekondensator C2 und einen Entladewiderstand R7, der dem Auswertekondensator C2 parallel geschaltet ist, wobei der Gegenkopplungswiderstand R1, die Emitter-Kollektor-Strecke des pnp-Transistors T1 und der Auswertekondensator C2 bzw. der Entladewiderstand R7 seriell zwischen den Ausgabeanschluss 11 der Rechteckspannungsquelle 10 und das Bezugspotential GND eingeschleift sind. An einem Verbindungsknoten N1 des Transistors T1 bzw. des Kollektors des Transistors T1 und des Auswertekondensators C2 steht die Spannung UOUT an, die ein Maß für die Kapazität des Sensorelements C1 ist.

Ein Sensorzweig der Schaltungsanordnung, über den das Sensorelement C1 mit der Rechteckspannung UR beaufschlagt ist, wird durch den Gegenkopplungswiderstand R1 und die Emitter-Basis-Strecke des Transistors T1 gebildet. Ein Strom im Sensorzweig, d.h. der Strom durch die Emitter-Basis-Strecke des Transistors T1, wird durch den Transistor T1 entsprechend verstärkt, wobei der Auswertekondensator C2 durch den Kollektorstrom des Transistors T1 geladen wird. Der Entladewiderstand R7 bewirkt, dass eine kontinuierliche Entladung erfolgt.

Bei einer Betätigung des kapazitiven Sensorelements C1 nimmt dessen Kapazität zu, wodurch für den hohen Zustand der Rechteckspannung UR der Strom im Sensorzweig bzw. der Strom durch die Emitter-Basis-Strecke des Transistors T1 zunimmt. Dies bewirkt, entsprechend verstärkt, eine Zunahme des Kollektorstroms, wodurch die Spannung UOUT ebenfalls zunimmt. Der Spannungspegel der Spannung UOUT ist folglich ein Maß für die Kapazität des Sensorelements C1. Durch Auswerten der Spannung UOUT, beispielsweise durch Vergleichen mit einem vorgegebenen Spannungsschellwert, kann weiter bestimmt werden, ob das kapazitive Sensorelement C1 betätigt ist oder nicht. Die gezeigte Schaltungsanordnung ist folglich auch zur Bestimmung des Betätigungszustands des kapazitiven Sensorelements C1 geeignet.

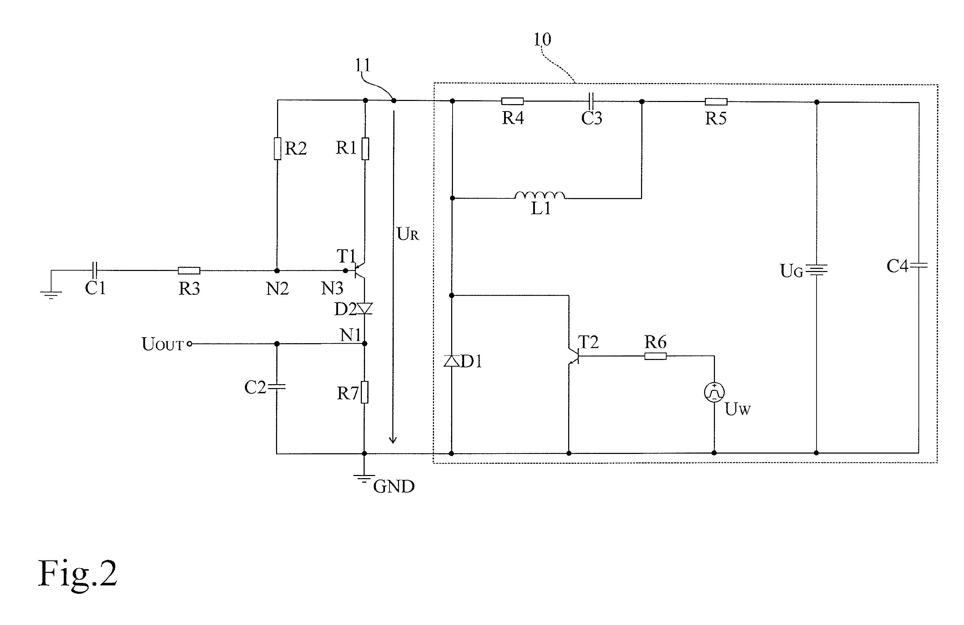

Fig. 2 zeigt ein Schaltbild einer weiteren Ausführungsform einer Schaltungsanordnung zum Bestimmen einer Kapazität des kapazitiven Sensorelements C1, dessen Kapazität sich in Abhängigkeit von seinem Betätigungszustand ändert. Nachfolgend werden nur die Unterschiede zu der in Fig. 1 gezeigten Schaltung beschrieben, hinsichtlich der übereinstimmenden Bestandteile sei folglich auf Fig. 1 verwiesen.

Der Verstärkerzweig umfasst weiter eine Diode D2, die in Durchflussrichtung zwischen den Transistor T1 und den Auswertekondensator C2 bzw. den Entladewiderstand R7 eingeschleift ist. Die Diode D2 verhindert ein Entladen des Auswertekondensators C2 über den Transistor T1 während Zeitintervallen, in denen die Rechteckspannung UR einen niedrigen Pegel aufweist, d.h. 0V, und erhöht somit die Auswerteempfindlichkeit. Die Diode D2 kann als Transistor ausgeführt sein, der als Diode beschaltet ist. Bevorzugt sind für diesen Fall der Transistor T1 und der als Diode beschaltete Transistor Teil eines Doppeltransistors.

Weiter ist ein Spannungsteiler umfassend Widerstände R2 und R3 vorgesehen, wobei der Spannungsteiler zwischen den Ausgabeanschluss 11 der Rechteckspannungsquelle 10 und einen Anschluss bzw. die erste Kondensatorplatte 30 des kapazitiven Sensorelements C1 eingeschleift ist. Ein Mittenabgriff N2 des Spannungsteilers ist mit dem Basisanschluss N3 des Transistors T1 verbunden. Der Spannungsteiler dient der Bedämpfung von Störungen.

Die in den Ausführungsformen gezeigten Schaltungsanordnungen können selbstverständlich auch zum Bestimmen einer Kapazität mehrerer kapazitiver Sensorelemente erweitert werden, indem pro Sensorelement jeweils ein Sensorzweig und ein Verstärkerzweig vorzusehen ist, die von der nur einfach vorzusehenden Rechteckspannungsquelle 10 mit der Rechteckspannung UR beaufschlagt werden.

Die gezeigten Ausführungsformen gewährleisten eine zuverlässige Kapazitätsbestimmung unter allen Betriebsbedingungen, sind kostengünstig herstellbar und unempfindlich gegenüber EMV- und HF-Störungen.

## Patentansprüche

1. Schaltungsanordnung zum Bestimmen einer Kapazität eines kapazitiven Sensorelements (C1), mit
- einer Rechteckspannungsquelle (10), die dazu ausgebildet ist, an einem Ausgabeanschluss (11) eine Rechteckspannung (UR) auszugeben,
- einem Sensorzweig, über den das Sensorelement mit der Rechteckspannung beaufschlagt ist, und
- einem Verstärkerzweig, umfassend
- einen Gegenkopplungswiderstand (R1),
- einen Transistor (T1) und
- einen Auswertekondensator (C2), wobei
- der Gegenkopplungswiderstand, der Transistor und der Auswertekondensator seriell zwischen den Ausgabeanschluss der Rechteckspannungsquelle und ein Bezugspotential (GND) eingeschleift sind und an dem Auswertekondensator eine Spannung (UOUT) ansteht, die ein Maß für die Kapazität des Sensorelements ist.

2. Schaltungsanordnung nach Anspruch 1, **dadurch gekennzeichnet, dass** die Rechteckspannungsquelle eine Ladungspumpe (R4, R5, R6, C3, C4, L1, D1, T2, UG, UW) umfasst.

3. Schaltungsanordnung nach Anspruch 1 oder 2, **dadurch gekennzeichnet, dass** die Rechteckspannungsquelle dazu ausgebildet ist, eine Rechteckspannung mit einem Spannungshub größer als 20V, bevorzugt größer als 30V, auszugeben.

4. Schaltungsanordnung nach einem der vorhergehenden Ansprüche, **dadurch gekennzeichnet, dass** die Rechteckspannungsquelle eine Zener-Diode (D1) umfasst, die zwischen den Ausgabeanschluss der Rechteckspannungsquelle und das Bezugspotential eingeschleift ist und die die Rechteckspannung auf einen maximalen Spannungspegel begrenzt.

5. Schaltungsanordnung nach einem der vorhergehenden Ansprüche, **dadurch gekennzeichnet, dass** der Transistor ein pnp-Transistor ist, wobei der Gegenkopplungswiderstand, die Emitter-Kollektor-Strecke des Transistors und der Auswertekondensator seriell zwischen den Ausgabeanschluss der Rechteckspannungsquelle und das Bezugspotential eingeschleift sind und der Basisanschluss des Transistors mit einem Anschluss (30) des kapazitiven Sensorelements verbunden ist.

6. Schaltungsanordnung nach einem der vorhergehenden Ansprüche, **gekennzeichnet durch** einen Entladewiderstand (R7), der dem Auswertekondensator parallel geschaltet ist.

7. Schaltungsanordnung nach einem der vorhergehenden Ansprüche, **gekennzeichnet durch** eine Diode (D2), die in Durchflussrichtung zwischen den Transistor und den Auswertekondensator eingeschleift ist.

8. Schaltungsanordnung nach einem der vorhergehenden Ansprüche, **gekennzeichnet durch**
- einen Spannungsteiler (R2, R3), wobei der Spannungsteiler zwischen den Ausgabeanschluss der Rechteckspannungsquelle und einen Anschluss des kapazitiven Sensorelements eingeschleift ist, wobei ein Mittenabgriff (N2) des Spannungsteilers mit einem Steuereingang (N3) des Transistors verbunden ist.
